# EUROPÄISCHE PATENTSCHRIFT

(11) **EP 2 302 782 B1**
(45) Veröffentlichungstag und Bekanntmachung des Hinweises auf die Patenterteilung: **03.04.2013**
(21) Anmeldenummer: 10170744.6
(22) Anmeldetag: 26.07.2010
(51) Int. Cl.: H02M 7/00

(54) **Stromrichteranordnung**
Frequency converter assembly
Agencement de convertisseur de courant

(30) Priorität: 26.09.2009 DE 102009043181
(43) Veröffentlichungstag der Anmeldung: 30.03.2011
(73) Patentinhaber: SEMIKRON Elektronik GmbH & Co. KG, 90431 Nürnberg (DE)
(72) Erfinder: Vanhyfte, François, 95360 Montmagny (FR); Allain, Briag, 78360 Montesson (FR)

(56) Entgegenhaltungen:
- EP-A1- 0 450 122
- EP-A2- 2 015 626
- DE-A1- 19 832 225
- US-A1- 2006 039 127
- US-A1- 2008 002 328

## Beschreibung

Die Erfindung beschreibt Stromrichteranordnungen, wie sie als Basismodul beispielhaft in Windkraft- oder Photovoltaikanlagen zur Anpassung der dort erzeugten Ströme an ein Versorgungsnetz dienen. Windkraftanlagen erzeugen abhängig von der Windgeschwindigkeit zeitlich variierende Ausgangsspannungen mit ebenso variierender Frequenz. In Photovoltaikanlagen wird üblicherweise zeitlich variierende Gleichspannung erzeugt. Zur Einspeisung in ein Versorgungsnetz ist es allerdings meist notwendig eine definierte Spannung konstanter Frequenz zu erzeugen.

Hierfür sind beispielhaft aus der DE 198 32 225 A1 kaskadierte Anordnungen von handelsüblichen Leistungshalbeitermodulen bekannt. Die Erfindung beschreibt eine Basismodul beispielhaft zum Aufbau derartiger kaskadierter Anordnungen, die bevorzugt für höhere Leistungen über 100kW geeignet ist. Hierdurch ist selbstverständlich die Verwendung dieses Basismoduls als Einzelmodul nicht eingeschränkt.

Aus der US 2008/0002328 A1 ist eine Verbindungseinrichtung bekannt, die zur Verbindung von Gleichspannungsanschlusselementen zweier Basismodule vorgesehen ist. Diese Verbindungseinrichtung besteht aus zwei leitfähigen Streifen als Klemmmittel, die beide in Kontakt mit zwei Gleichspannungsanschlusselementen einer Polarität zugeordneter Basismodule stehen und wobei dieses jeweilige Gleichspannungsanschlusselement zwischen die beiden Klemmmittel geklemmt ist.

US 2006/0039127 A1 offenbart eine niederinduktive Verbindung eines Substrats mit hierauf angeordneten Leistungshalbleiterbauelementen und einer darüber angeordneten Leiterplatte mit einer Mehrzahl von Kondensatoren. Zur elektrisch leitenden Verbindung der Leiterbahnen der Leiterplatte mit den Kondensatoren zu den zugeordneten Leiterbahnen des Substrats ist jeweils eine Klemmvorrichtung vorgesehen. Den elektrischen Kontakt innerhalb dieser Klemmvorrichtung stellt ein Kontaktmittel da, das zwischen Leiterbahn und Substrat geklemmt ist.

EP 2 015 626 A2 offenbart in Fig. 7 und 8 eine niederinduktive Verbindung eines Stromrichters mit Stromschienen, die zwei Gewindezapfen verwendet, so dass eines der Verbindungsmittel mit einer Ausnehmung zu versehen ist, was die Herstellung erschwert.

Der Erfindung liegt die Aufgabe zugrunde eine Stromrichteranordnung aufgebaut aus identischen Stromrichterbaugruppen vorzustellen, wobei die Stromrichteranordnung besonders kompakt ausgebildet ist und die zwischen den Stromrichterbaugruppen niederinduktive und hoch stromtragfähige Gleichstromverbindungen aufweist.

Diese Aufgabe wird erfindungsgemäß gelöst, durch eine Stromrichteranordnung mit den Merkmalen des Anspruchs 1. Bevorzugte Ausführungsformen sind in den abhängigen Ansprüchen beschrieben.

Den Ausgangspunkt der Erfindung bildet eine Stromrichteranordnung ausgebildet aus einer Mehrzahl von vorzugsweise identischen Stromrichterbaugruppen.
Jede dieser Stromrichterbaugruppen weist einen Kühlkörper zur Luft- oder Flüssigkeitskühlung auf. Dieser Kühlkörper trägt mindestens ein, vorzugsweise eine Mehrzahl von gleichartigen Leistungshalbleitermodulen. Es ist weiterhin bevorzugt, wenn diese Leistungshalbleitermodule als Halbbrückenschaltungen ausgebildet und parallel geschaltet sind, wodurch sie wie eine Halbbrückenschaltung mit der mehrfachen Leistung eines einzelnen Leistungshalbleitermoduls wirken.

Eng benachbart zu diesem mindestens einen Leistungshalbleitermodul ist eine Kondensatoreinrichtung, die vorzugsweise aus einer Parallelschaltung einer Mehrzahl gleicher Kondensatoren besteht angeordnet. Es ist weiterhin vorteilhaft, wenn die Kondensatoreinheit auf der Kühleinrichtung angeordnet ist, da hierdurch ein besonders kompakter und mechanisch stabiler Aufbau gewährleistet ist. Die Kondensatoreinrichtung bilden vorzugsweise den Gleichstromzwischenkreis einer mit der Stromrichteranordnung realisierten leistungselektronischen Schaltung aus.

Hierzu ist die Kondensatoreinrichtung mit den Gleichstromanschlusselementen des mindestens einen Leistungshalbleitermoduls mittels einer Verschienung verbunden. Diese Verschienung ist besonders niederinduktiv, wenn sie flächig ausgebildet ist, also aus zwei eng benachbart angeordneten flächigen Metallformkörpern mit einer isolierenden Zwischenlage ausgebildet ist. In ihrem Verlauf überdeckt die Verschienung die Kondensatoreinrichtung in mindestens einer Ausrichtung, vorzugsweise derjenigen in der weitere Stromrichterbaugruppen angeordnet werden.

Zur niederinduktiven und eine hohe Stromtragfähigkeit aufweisenden Verbindung zweier Stromrichterbaugruppen sind die jeweiligen, ersten und zweiten Metallformkörper der Verschienung mittels zugeordneter erster und zweiter Verbindungskörper miteinander elektrisch leitend verbunden. Die jeweiligen Verbindungskörper selbst sind vorteilhafterweise ebenso wie die Metallformkörper der Verschienung als flächige Metallformkörper ausgebildet. Hierfür bieten sich jeweils Metallbleche geeigneter Stärke aus einem hochleitfähigen Metall, wie beispielhaft Kupfer, an.

Zur Ausbildung der elektrisch leitfähigen Verbindung der jeweiligen Metallformkörper der Verschienung mit den jeweiligen Verbindungskörpern sind geeignete Verbindungseinrichtungen derart vorgesehen, dass die geringe Induktivität der Verschienung auch für die Verbindung zumindest annährend erhalten bleibt. Hierzu ist es besonders wesentlich, dass der Abstand der ersten und zweiten Verbindungskörper zueinander nicht wesentlich größer ausgebildet ist als der Abstand der Metallformkörper der Verschienung. Ebenso ist eine weitere isolierende Zwischenlage zwischen den Verbindungskörper vorzusehen. Zur Ausführung der Erfindung ist es weiterhin wesentlich, dass der zweite Verbindungskörper den ersten Verbindungskörper überdeckt. Somit besteht in Kombination mit den geeigneten Verbindungsmitteln eine niederinduktive, mechanisch robuste und hoch stromtragfähige Verbindung einer Mehrzahl von Stromrichterbaugruppen zu einer erfindungsgemäßen Stromrichteranordnung.

Besonders bevorzugte Weiterbildungen der Erfindung sind in der jeweiligen Beschreibung der Ausführungsbeispiele genannt. Die erfinderische Lösung wird zudem an Hand der Ausführungsbeispiele und der Fig. 1 bis 5 weiter erläutert.

Fig. 1 zeigt eine Stromrichterbaugruppe einer erfindungsgemäßen Stromrichteranordnung in dreidimensionaler Ansicht.

Fig. 2 und 3 zeigen die Stromrichterbaugruppe in zwei verschiedenen zweidimensionalen Ansichten.

Fig. 4 zeigt eine erfindungsgemäße Stromrichteranordnung.

Fig. 5 zeigt in einer Teilansicht die Verbindung zweier Stromrichterbaugruppen einer erfindungsgemäßen Stromrichteranordnung.

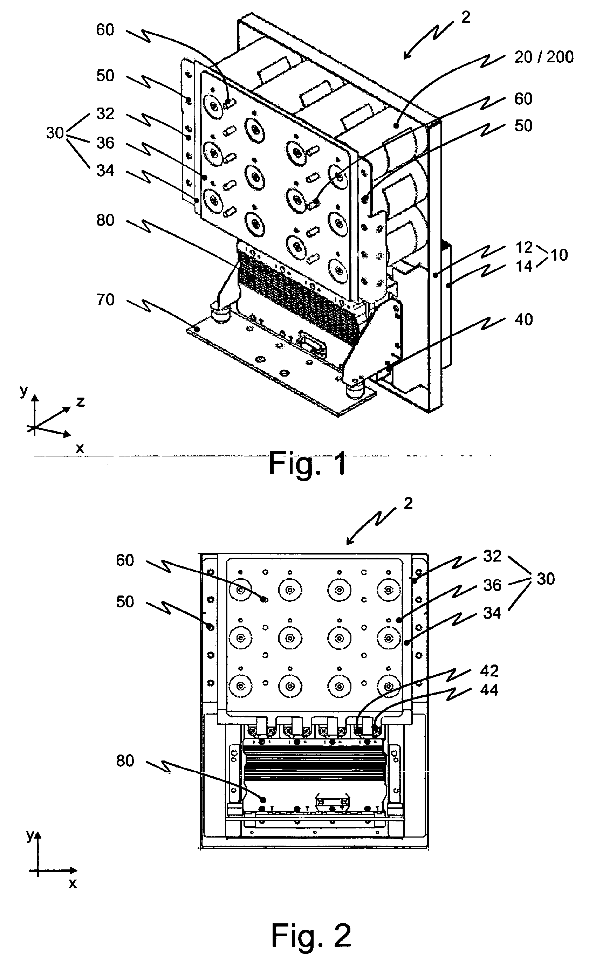

Fig. 1 zeigt als Teil einer erfindungsgemäßen Stromrichteranordnung (1) eine Stromrichterbaugruppe (2) mit einer Kühleinrichtung (10), einer Mehrzahl von Leistungshalbleitermodulen (40) und einer Kondensatoreinrichtung (20) in dreidimensionaler Ansicht. Dargestellt ist die Kühleinrichtung (10), die hier ausgebildet ist als eine Grundplatte (12) mit einem Kühlmittel (14), hier in Form von Finnen einer Luftkühleinrichtung. Ebenso ist eine Ausgestaltung mit einer Flüssigkeitskühlung denkbar, die durch die höhere Kühlleistung eine höhere elektrische Leistung der Stromrichterbaugruppe (2), im Bereich von einem Megawatt, gestattet. Hier dargestellt sind die Kühlmittel (14) aus Gründen der Kühleffizienz unterhalb der Leistungshalbleitermodule (40). Ebenso kann eine Ausdehnung über den gesamten Bereich der Grundplatte (12) vorteilhaft sein, um die Kühlleistung weiter zu erhöhen.

Die Kondensatoreinrichtung (20) ist ebenfalls auf der Grundplatte (12) der Kühleinrichtung (10) angeordnet und besteht ihrerseits aus einer Mehrzahl gleichartiger Kondensatoren (200). Zur effizienten und niederinduktiven Anbindung an die Leistungshalbleitermodule (40) ist die Kondensatoreinrichtung (20) unmittelbar benachbart zu den Gleichstromanschlusselementen (42, 44, vgl. Fig. 2) der Leistungshalbleitermodule (40) angeordnet. Durch die gemeinsame Anordnung der Leistungshalbleiterbauelemente (40) und der Kondensatoreinrichtung (20) auf der Kühleinrichtung (10) ergibt sich eine sehr kompakte und mechanisch stabile Einheit der Stromrichterbaugruppe (2).

Die Leistungshalbleitermodule (40) selbst weisen jeweils eine Halbbrückenschaltung auf und sind miteinander parallel verschaltet um die gewünschte Leistung der Stromrichterbaugruppe (2) zu erreichen. Direkt auf den Leistungshalbleitermodulen (40), auf deren der Kühleinrichtung (10) abgewandten Seite, ist die Ansteuerschaltung (80) in einem eigenen Teilgehäuse angeordnet. Diese Anordnung erzielt durch ihre kurzen Wege für die Steuersignale eine besonders hohe Störsicherheit gegen externe Störsignale. Weiterhin weisen die Leistungshalbleitermodule (40) auf der der Kondensatoreinrichtung (20) abgewandten Seite ein gemeinsames Wechselstromanschlusselement (70) auf, das den Ausgang der Halbbrückenschaltung ausbildet.

Die elektrische Verbindung der Gleichstromanschlusselemente (42, 44) der Leistungshalbleitermodule (40) mit der Kondensatoreinrichtung (20) erfolgt mittels einer geeigneten, hier in ihrem Verlauf z- förmig ausgebildeten, Verschienung (30). Diese Verschienung (30) besteht aus einem ersten (32) und einem zweiten (36) Metallformkörper mit einer isolierenden Zwischenlage (34). Die jeweiligen Metallformkörper (32, 36) weisen zur Verbindung mit den Gleichstromanschlusselementen (42, 44) einzelne Laschen auf. Im weiteren Verlauf zu den einzelnen Kondensatoren (200) der Kondensatoreinrichtung (20) sind die Metallformkörper (32, 36) der Verschienung (30) flächig ausgebildet. Die flächigen Metallformkörper (32, 36) der Verschienung (30) überragen hier die Kondensatoreinheit (20) in beiden Ausrichtungen. Notwendig ist hier nur eine Überlappung in Richtung einer nächsten anzuordnenden Stromrichterbaugruppe, hier der y- Richtung.

Der erste Metallformkörper (32) der Verschienung (30) verbindet die negativen Gleichspannungsanschlusselemente (42) der Leistungshalbleiterbauelemente (40) polaritätsgerecht mit den zugeordneten Anschlusselementen der Kondensatoren (200) der Kondensatoreinrichtung (20). In gleicher Weise verbindet der zweite Metallformkörper (36) die positiven Gleichspannungsanschlusselemente (44) der Leistungshalbleitermodule (40) polaritätsgerecht mit den zugeordnet Anschlusselementen der Kondensatoren (200) der Kondensatoreinrichtung (20). Zu dieser Verbindung weist der erste Metallformkörper (32) Ausnehmungen auf, durch die die Anschlusselemente der Kondensatoren (200) isoliert hindurchreichen.

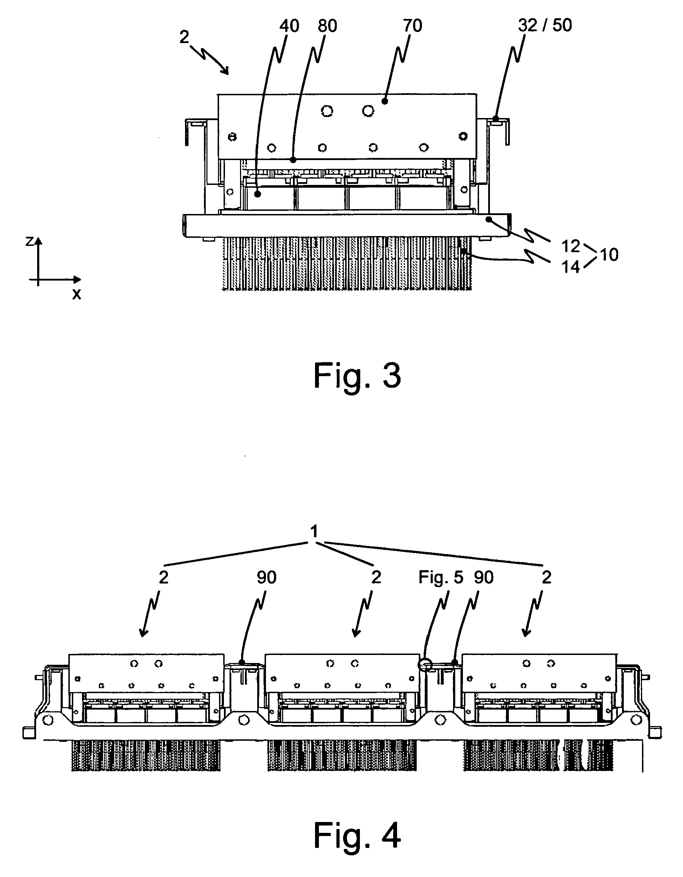

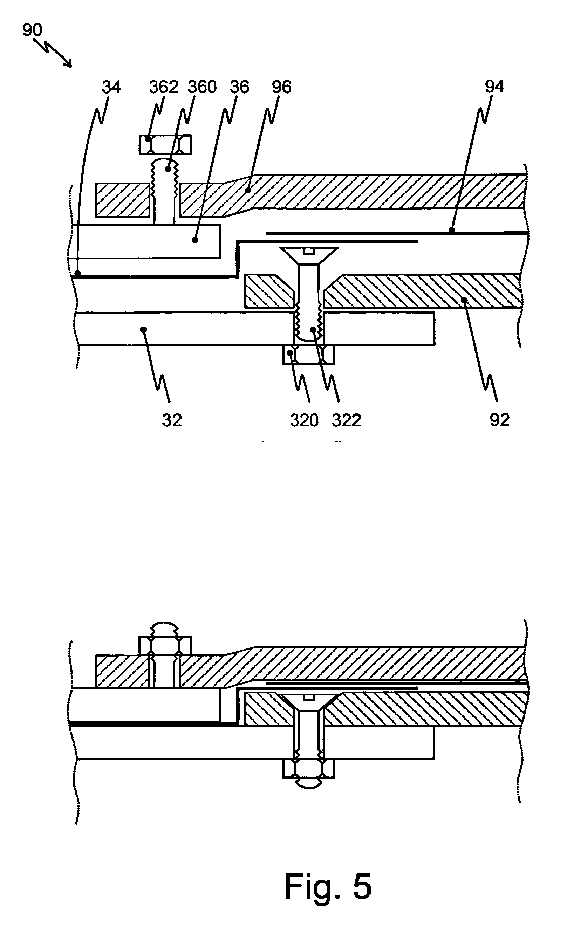

Der erste Metallformkörper (32) weist in seinen Randbereichen, die die Kondensatoreinrichtung (20) überlappen, Schraubaufnahmen (50) auf, die mit den ersten Verbindungsmitteln zur niederinduktiven hoch stromtragfähigen Verbindung (90, vgl. Fig. 4) dieser Stromrichterbaugruppe (2) zu einer benachbarten Stromrichterbaugruppe darstellen und in Fig. 5 detailliert beschrieben sind.

Der zweite Metallformkörper (36) weist nahe zweier seiner Randbereiche mehrere Gewindezapfen (60) auf, die mit den zweiten Verbindungsmitteln (360, 362) zur niederinduktiven hoch stromtragfähigen Verbindung (90) dieser Stromrichterbaugruppe (2) zu einer benachbarten Stromrichterbaugruppe darstellen und in Fig. 5 detailliert beschrieben sind.

Fig. 2 und 3 zeigen die Stromrichterbaugruppe (2) gemäß Fig. 1 in zwei verschiedenen zweidimensionalen Ansichten. In Fig. 2 sind sowohl die flächige Verschienung (30) wie auch die Schraubaufnahmen (50) des ersten Metallformkörpers (32) der Verschienung (30) und auch die Gewindezapfen (60) des zweiten Metallformkörper (36) der Verschienung (30) deutlich ersichtlich. Ebenso sind hier die Gleichstromanschlüsse (42, 44) der Leistungshalbleitermodule (40) sowie die damit verbundenen Laschen der Metallformkörper (32, 36) der Verschienung (30) erkennbar.

Fig. 3 zeigt deutlich die Kühleinrichtung (10) mit der Grundplatte (12) und den Kühlfinnen (14) als Kühlmittel. Auf dieser Grundplatte (12) sind die Leistungshalbleitermodule (40) angeordnet. Mit diesen sind einerseits das Wechselstromanschlusselement (70) wie auch die Verschienung (30) zur Kondensatoreinrichtung (20) verbunden. Dargestellt ist auch die Schraubaufnahme (50) des ersten Metallformkörpers (32).
Fig. 4 zeigt eine erfindungsgemäße Stromrichteranordnung (1). Diese weist drei Stromrichterbaugruppen (2) auf, die untereinander ein Verbindung (90) aufweisen. Hierzu sind die Verschienungen (30), die die Kondensatoren (200) der Kondensatoreinrichtung (20) der jeweiligen Stromrichterbaugruppe (2) kontaktieren miteinander verbunden. Bei dem hier dargestellten dreiphasigen Wechselrichter, wobei jeder Phase eine Stromrichterbaugruppe (2) zugeordnet ist, dient diese Verbindung (90) der gleichmäßigen Lastverteilung auf die drei Kondensatoreinrichtungen (20). Wesentlich ist hierfür die niederinduktive Verbindung und hohe Stromtragfähigkeit der hergestellten Verbindung (90).

Fig. 5 zeigt in einer Teilansicht die Verbindung (90) zweier Stromrichterbaugruppen (2) einer erfindungsgemäßen Stromrichteranordnung zusätzlich auch mittels einer Explosionszeichnung. Dargestellt ist die Verschienung (30) mit jeweils einem ersten (32) und einem zweiten (36) Metallformkörper, sowie eine dazwischen angeordnete isolierende Zwischenlage (34).

Zur Verbindung des ersten Metallformkörpers (32) ist ein erstes Verbindungsmittel vorgesehen. Hierbei weist der erste Metallformkörper (32) eine Ausnehmung und auf der der Kondensatoreinrichtung zugewandten Seite eine Schraubaufnahme (320) auf. Weiterhin ist ein erster Verbindungskörper (92) vorgesehen, der ebenfalls eine Ausnehmung zur Aufnahme einer Schraube (322) aufweist. Dieser erste Verbindungskörper (92) ist derart zum ersten Metallformkörper (32) angeordnet, dass die beiden Ausnehmungen zueinander fluchten. Durch Anordnen der Schraube (322) wird eine kraftschlüssige elektrisch leitende Verbindung zwischen dem ersten Metallformkörper (32) und dem ersten Verbindungskörper (92) hergestellt. Da der erste Verbindungskörper (92) vorteilhafterweise die gleich Länge (y- Richtung) wie der erste Metallformkörper (32) aufweist entsteht so eine elektrische Verbindung hoher Stromtragfähigkeit.

Zur Verbindung des zweiten Metallformkörpers (36) ist ein zweites Verbindungsmittel vorgesehen. Hierbei weist der zweite Metallformkörper (36) einen Gewindezapfen (360) auf. Weiterhin ist ein zweier Verbindungskörper (96) vorgesehen, der eine Ausnehmung zur Aufnahme dieses Gewindezapfens (360) aufweist. Der zweite Metallformkörper (36) ist durch Anordnung einer Mutter (362) auf dem Gewindezapfen (360) kraftschlüssig mit dem zweiten Verbindungskörper (96) verbunden. Da auch der zweite Verbindungskörper (96) vorteilhafterweise die gleiche Länge (y- Richtung) wie der zweite Metallformkörper (36) aufweist hat auch diese Verbindung eine hohe Stromtragfähigkeit. Durch die Ausbildung dieser Verbindung überdeckt der zweite (36) Verbindungskörper den ersten (32) vollständig.

Durch die beschriebene Ausgestaltung der Verbindung (90) zweier Stromrichterbaugruppen (2) ist deren Stromtragfähigkeit gewährleistet. Die niederinduktive Verbindung ist dadurch gewährleistet, dass durchgängig sowohl zwischen den Metallformkörpern (32, 36), zwischen den Verbindungskörpern (92, 96) und auch im Übergangsbereich zwischen Metallformkörper und Verbindungskörpern der jeweilige Abstand minimal ist.

Ein weiterer Vorteil der erfindungsgemäßen Verbindung (90) zweier Stromrichterbaugruppen (2) ist, dass diese einer einfachen Herstellung zugänglich ist, da in einem sequenziellen Verfahren erst die erste Verbindungseinrichtung anschließend die zugeordnete weitere isolierende Zwischenlage (94) und daran anschließend die zweite Verbindungseinrichtung angeordnet werden können. Wesentlich hierbei ist zudem, dass all diese Herstellungsschritte von der der Kondensatoreinrichtung abgewandten Seite aus durchgeführt werden können.

## Patentansprüche

1. Stromrichteranordnung (1) mit
einer Mehrzahl von Stromrichterbaugruppen (2) mit jeweils einer Kühleinrichtung (10), mindestens einem hierauf angeordneten Leistungshalbleitermodul (40) und mit einer hiermit schaltungsgerecht verbundenen Kondensatoreinrichtung (20) je Stromrichterbaugruppe (2),
wobei das mindestens eine Leistungshalbleitermodul (40) zu der Kondenstoreinrichtung (20) eng benachbart angeordnet ist und Gleichstromlastanschlusselemente (42, 44) des Leistungshalbleitermoduls (40) mittels einer flächig ausgebildeten Verschienung (30) mit der Kondensatoreinrichtung (20) verbunden sind, wobei die flächige Verschienung (30) aus einem ersten (32) und zweiten (36) Metallformkörper mit einer isolierenden Zwischenlage (34) gebildet ist und die Kondensatoreinrichtung (20) in mindestens einer Ausrichtung überdeckt, und wobei die Verschienungen (30) zweier benachbart angeordneter Stromrichterbaugruppen (2) miteinander niederinduktiv verbindbar sind indem die ersten Metallformkörper (32) mittels eines ersten flächigen Verbindungskörpers (92) und ersten Verbindungsmitteln (320, 322) verbunden sind indem die zweiten Metallformkörper (36) mittels eines zweiten flächigen Verbindungskörpers (96) und zweiten Verbindungsmitteln (360, 362) verbunden sind, wobei der erste Verbindungskörper (92) von dem zweiten Verbindungskörper (96) überdeckt ist,
wobei zwischen den beiden Verbindungskörpern (92, 96) eine weitere isolierende Zwischenlage (94) angeordnet ist,
wobei das erste Verbindungsmittel (320, 322) als eine kraftschlüssige Schraubverbindung ausgebildet ist, wobei der erste Metallformkörper (32) eine Schraubaufnahme (50) und der erste Verbindungskörper (92) eine Ausnehmung zur Aufnahme einer Schraube (322) der Schraubverbindung aufweist und wobei der Kraftschluss durch Anordnen der Schraube (322) in der Ausnehmung sowie der Schraubaufnahme (320) besteht und
wobei das zweite Verbindungsmittel (360, 362) als eine kraftschlüssige Schraubverbindung ausgebildet, wobei der zweite Metallformkörper (36) einen Gewindezapfen (360) und der zweite Verbindungskörper (96) eine Ausnehmung zur Durchführung dieses Gewindezapfens (360) aufweist und wobei der Kraftschluss durch Anordnen einer Mutter (362) auf dem Gewindezapfen (360) besteht.

2. Stromrichteranordnung nach Anspruch 1,
wobei die Kondensatoreinrichtung (20) eine Mehrzahl von Kondensatoren (200) aufweist und diese Anschlusselemente aufweisen, die polaritätsgerecht mit dem jeweils zugeordneten ersten (32) oder zweiten (36) Metallformkörper der Verschienung (30) verbunden sind.

3. Stromrichteranordnung nach Anspruch 1,
wobei der erste Metallformkörper (32) Ausnehmungen aufweist zur isolierten Durchführung von polaritätsunterschiedlichen Anschlusselementen der Kondensatoren (200) der Kondensatoreinrichtung (20).

4. Stromrichteranordnung nach Anspruch 1,
wobei die Kondensatoreinrichtung (20) auf der Kühleinrichtung (10) angeordnet ist.

5. Stromrichteranordnung nach Anspruch 1,
wobei ein Wechselstromanschlusselement (70) des mindestens einen Leistungshalbleitermoduls (40) auf der der Kondensatoreinrichtung (20) abgewandten Seite des jeweiligen Leistungshalbleitermoduls (40) angeordnet ist.

6. Stromrichteranordnung nach Anspruch 1,
wobei auf der der Kühleinrichtung (10) abgewandten Seite des mindestens einen Leistungshalbleitermoduls (40) einer Stromrichterbaugruppe (2) eine Ansteuerschaltung (80) angeordnet ist.

## Claims

1. Power converter assembly (1) having
a plurality of power converter units (2) each having a cooling device (10), at least one power semiconductor module (40) arranged thereon and having one capacitor device (20) per power converter unit (2) connected thereto in accordance with the circuitry, wherein the at least one power semiconductor module (40) is arranged closely adjacent to the capacitor device (20) and d.c. load terminal elements (42, 44) of the power semiconductor module (40) are connected to the capacitor device (20) by means of planar busbars (30), wherein the planar busbars (30) are composed of a first (32) and a second (36) shaped metal body with an insulating intermediate layer (34) and overlap the capacitor device (20) in at least one direction, and wherein the busbars (30) of two adjacent power converter units (2) can be connected to each other in low-inductance relationship by the fact that the first shaped metal bodies (32) are connected by means of a first planar connecting element (92) and first connecting means (320, 322) by the fact that the second shaped metal bodies (36) are connected by means of a second planar connecting element (96) and second connecting means (360, 362), wherein the first connecting element (92) is overlapped by the second connecting element (96),
wherein between the two connecting elements (92, 96) is arranged an additional insulating intermediate layer (94),
wherein the first connecting means (320, 322) is designed as a force-fit screw-type connection, wherein the first shaped metal body (32) has a screw-type receptacle (50) and the first connecting element (92) has a recess for receiving a screw (322) of the screw-type connection and wherein the force fit is provided by arranging the screw (322) in the recess and the screw-type receptacle (320) and
wherein the second connecting means (360, 362) is designed as a force-fit screw-type connection, wherein the second shaped metal body (26) has a threaded pin (360) and the second connecting element (96) has a recess for the passage of this threaded pin (360) and wherein the force fit is provided by arranging a nut (362) on the threaded pin (360).

2. Power converter assembly according to claim 1,
wherein the capacitor device (20) has a plurality of capacitors (200) and the latter have terminal elements which are connected in accordance with polarity to the respectively associated first (32) or second (36) shaped metal body of the busbars (30).

3. Power converter assembly according to claim 1,
wherein the first shaped metal body (32) has recesses for the insulated passage of terminal elements of the capacitors (200) of the capacitor device (20) having different polarity.

4. Power converter assembly according to claim 1,
wherein the capacitor device (20) is arranged on the cooling device (10).

5. Power converter assembly according to claim 1,
wherein an a.c. terminal element (70) of the at least one power semiconductor module (40) is arranged on the side of the respective power semiconductor module (40) facing away from the capacitor device (20).

6. Power converter assembly according to claim 1,
wherein on the side facing away from the cooling device (10), of the at least one power semiconductor module (40) of a power converter unit (2), is arranged a control circuit (80).

## Revendications

1. Dispositif de convertisseur (1), avec :
une pluralité de groupes de convertisseur (2) ayant chacun un dispositif de refroidissement (10), au moins un module semi-conducteur de puissance (40) disposé sur celui-ci, et avec un dispositif de condensateur (20), qui lui est relié par circuit adapté, par groupe de convertisseur (2),
l'au moins un module semi-conducteur de puissance (40) étant disposé de manière étroitement contiguë au dispositif de condensateur (20), et des éléments de connexion de charge à courant continu (42, 44) du module semi-conducteur de puissance (40) étant reliés au dispositif de condensateur (20) au moyen d'une barre (30) réalisée avec une forme plate, ladite barre (30) plate étant constituée d'un premier (32) et d'un deuxième (36) corps moulé métallique avec un intercalaire (34) isolant et recouvrant le dispositif de condensateur (20) dans au moins une direction, et les barres (30) de deux groupes de convertisseur (2) contigus pouvant être reliées l'une à l'autre à faible inductance en connectant le premier corps moulé métallique (32) au moyen d'un premier corps de connexion (92) plat et de premiers moyens de connexion (320, 322), en connectant le deuxième corps moulé métallique (36) au moyen d'un deuxième corps de connexion (96) plat et de deuxièmes moyens de connexion (360, 362), le premier corps de connexion (92) étant recouvert par le deuxième corps de connexion (96),
un autre intercalaire (94) isolant étant disposé entre les deux corps de connexion (92, 96),
le premier moyen de connexion (320, 322) étant réalisé comme connexion filetée mécanique, le premier corps moulé métallique (32) comportant un logement de vis (50) et le premier corps de connexion (92) un évidement pour la réception d'une vis (322) de la connexion filetée, et l'assemblage mécanique étant obtenu par disposition de la vis (322) dans l'évidement ainsi que dans le logement de vis (320), et
le deuxième moyen de connexion (360, 362) étant réalisé comme connexion filetée mécanique, le deuxième corps moulé métallique (36) comportant une goupille filetée (360) et le deuxième corps de connexion (96) un évidement pour le passage de ladite goupille filetée (360), et l'assemblage mécanique étant obtenu par disposition d'un écrou (362) sur la goupille filetée (360).

2. Dispositif de convertisseur selon la revendication 1, dans lequel le dispositif de condensateur (20) comporte une pluralité de condensateurs (200) comprenant des éléments de connexion qui sont reliés en fonction de la polarité au premier (32) ou au deuxième (36) corps moulé métallique respectivement associé de la barre (30).

3. Dispositif de convertisseur selon la revendication 1, dans lequel le premier corps moulé métallique (32) présente des évidements pour le passage isolé d'éléments de connexion de polarités différenciées des condensateurs (200) du dispositif de condensateur (20).

4. Dispositif de convertisseur selon la revendication 1, dans lequel le dispositif de condensateur (20) est disposé sur le dispositif de refroidissement (10).

5. Dispositif de convertisseur selon la revendication 1, dans lequel un élément de connexion à courant alternatif (70) de l'au moins un module semi-conducteur de puissance (40) est disposé sur le côté du module semi-conducteur de puissance (40) distant du dispositif de condensateur (20).

6. Dispositif de convertisseur selon la revendication 1, dans lequel un circuit de commande (80) est disposé sur le côté de l'au moins un module semi-conducteur de puissance (40) d'un groupe de convertisseur (2) distant du dispositif de refroidissement (10).
